# EUROPÄISCHE PATENTSCHRIFT

(11) **EP 0 705 183 B1**
(45) Veröffentlichungstag und Bekanntmachung des Hinweises auf die Patenterteilung: **05.03.1997**
(21) Anmeldenummer: 94916896.7
(22) Anmeldetag: 10.06.1994
(51) Int. Cl.: B60R 16/02

(54) **ANBAUSTEUERGERÄT**
BUILT-ON CONTROL DEVICE
APPAREIL DE COMMANDE AUXILIAIRE

(30) Priorität: 26.06.1993 DE 4321331
(43) Veröffentlichungstag der Anmeldung: 10.04.1996
(73) Patentinhaber: ROBERT BOSCH GMBH, 70442 Stuttgart (DE)
(72) Erfinder: JAKOB, Gert, D-70378 Stuttgart (DE); SCHIMITZEK, Ralph, D-74219 Möckmühl (DE)
(86) Internationale Anmeldenummer: DE9400648
(87) Internationale Veröffentlichungsnummer: WO9500363

(56) Entgegenhaltungen:
- WO-A-92/12875
- WO-A-93/09656
- DE-A- 3 833 146
- DE-A- 3 936 906
- DE-A- 3 942 392
- AUTOMOTIVE ENGINEERING, Bd.100, Nr.3, März 1992, WARRENDALE ,US Seiten 13 - 15, XP265650 CASSON 'ELECTRONIC HIGH - DENSITY PACKAGING FOR UNDER THE HOOD'

## Beschreibung

### Stand der Technik

Die Erfindung geht aus von einem Anbausteuergerät nach der Gattung des Hauptanspruchs. Ein derartiges Anbausteuergerät ist beispielsweise aus der nachveröffentlichten DE-PS 42 25 358.6 bekannt. Dort ist in einem haubenartigen, einteiligen Gehäuse eine Leiterplatte, auf der eine Leiterfolie befestigt ist, angeordnet. Hier ist zwar die Leiterplatte in mehrere starre Bereiche aufgeteilt, die aufgrund der Leiterfolie durch flexible Abschnitte verbunden sind. Die Anschlüsse der Verbraucher und auch die Anschlüsse der Stecker sind aber im Bereich der starren Leiterplatte mit dieser kontaktiert. Dadurch sind die jeweiligen Anschlüsse der Leiterplatte exakt aufeinander abzustimmen. Ferner ist das Gehäuse einteilig ausgebildet, wodurch der anschließende, bzw. abschließende Fertigungsprozeß erschwert wird.

Bei einem in der DE-A1 39 36 906 in der Figur 5 dargestellten Steuergerät ist mit Hilfe eines im Deckel des Steuergeräts angeordneten Steckers eine Verbindung zu einem Verbraucher herstellbar. Im Inneren des Gehäuses des Steuergeräts ist der Stecker an eine flexible Leiterfolie angebunden. Nach wie vor ist aber die Verbindung des Steuergeräts und des Verbrauchers unverändert starr vorgeschlagen, so daß das Steuergerät und der über den Stecker angeschlossene Verbraucher exakt aufeinander abgestimmt sein müssen. Aufgrund des Deckels, der eine Art Zwischenglied darstellt, werden zwei separat herstellbare und verwendbare Baueinheiten miteinander verbunden. Die Problematik eines Anbausteuergeräts, bei dem die Anschlüsse des Verbrauchers direkt in das Gehäuse des Steuergeräts und dort auch direkt mit der Leiterplatte verbunden werden, wird bei diesem Steuergerät nicht hervorgerufen.

### Vorteile der Erfindung

Das erfindungsgemäße Anbausteuergerät mit den kennzeichnenden Merkmalen des Hauptanspruchs hat demgegenüber den Vorteil, daß es für einen abschließenden Fertigungsprozeß bzw. für einen Abgleich der elektrischen Bauteile leicht zu öffnen ist. Die Lötstellen des Steuergeräts sind dadurch leicht zugänglich. Da die Leiterfolie direkt an der Innenseite des Deckels angeordnet ist, ergibt sich eine gute Kühlwirkung, die, insbesondere in diesem Bereich, keiner zusätzlichen Kühlelemente bedarf. Im Bereich der Kontaktierung der Verbraucher mit der Leiterplatte ergibt sich aufgrund der elastischen Folie eine Bewegungsfreiheit. Dadurch können die Kontakte nicht abbrechen oder werden sonst nicht beschädigt. Durch die Verwendung einer elastischen Folie ergibt sich im Bereich der Schleife zwischen den starren Bereichen der Leiterplatte keine Knickgefahr. Aufgrund der schräg verlaufenden Kante des Gehäuses baut dieses sehr kostengünstig. Die Verschraubungen des Gehäuses auf dem zu steuernden Hydroaggregat ist dadurch möglich. Die Wärmeabfuhr von den elektrischen Bauteilen wird vereinfacht. Die Länge des elastischen Bereichs zwischen den beiden starren Teilen der Leiterplatte wird verringert. Da die flexible Folie direkt an die Steckerkontakte angebunden ist, kann die Leiterplatte auch in diesem Bereich mit Leistungsbauelementen bestückt werden. Die Abdichtung zwischen dem Anbausteuergerät und dem Hydroaggregat ist einfach und gut. Bei mehrteiligen Gehäusen für das Anbausteuergerät können einzelne Gehäuseteile der äußeren Form des Gehäuses des Hydroaggegats korrespondierend angepaßt werden, wodurch zusätzliche, insbesondere großvolumige Leistungsbauelemente zusätzlich im Anbausteuergerät eingebaut werden können.

Weitere Vorteile und vorteilhafte Ausbildungen der Erfindung ergeben sich aus den Unteransprüchen und der Beschreibung.

### Zeichnung

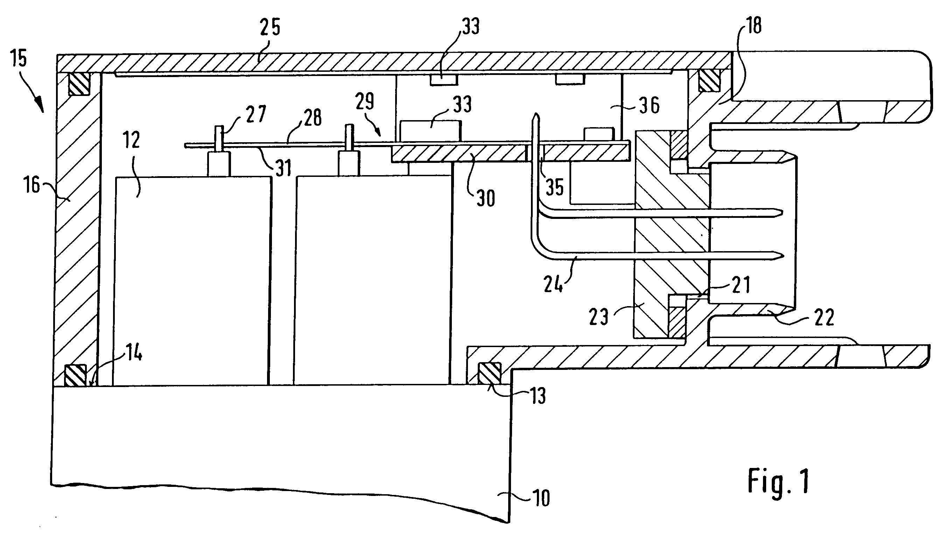

Ausführungsbeispiele der Erfindung sind in der nachfolgenden Beschreibung und der Zeichnung dargestellt. Es zeigen die Figuren 1 bis 3 jeweils einen Schnitt durch ein schematisch dargestelltes Anbausteuergerät, wobei das Hydroaggregat jeweils nur angedeutet ist.

### Beschreibung der Ausführungsbeispiele

In Figur 1 ist mit 10 der nur teilweise dargestellte Gehäuseblock des Hydroaggeregats eines hydraulischen Brems-Blockierschutz-Systems (schlupfgeregelte hydraulische Bremsanlage) dargestellt, an den ein nicht dargestellter Motor anflanschbar ist, der mit einer im Gehäuseblock 10 angeordneten - nicht dargestellten - Hydraulikpumpe und mit ebenfalls im Gehäuseblock angeordneten Magnetventilen 12 auf ansich bekannte Weise zusammenwirkt. An der dem Motor 11 gegenüberliegenden Stirnseite 13 des Gehäuseblocks 10 liegt die offene Stirnseite des Anbausteuergeräts 15 an, dessen mehrteiliges Gehäuse 16 als wannenförmiger Deckel ausgebildet ist.

Im Gehäuseblock 10 des Hydroaggregats sind mehrere Magnetventile 12 angeordnet, von denen in der Figur 1 zwei ersichtlich sind. Diese ragen mit ihren anschluß- bzw. antriebsseitigen Enden bis in den Innenraum 17 des Anbausteuergeräts 15.

Das Gehäuse 16 hat im Rahmen 18 eine seitliche Steckeröffnung 21 mit einem kragenförmigen Aufnahmeschacht 22. In die Steckeröffnung 21 ist abgedichtet die Messerleiste 23 mit den Steckerelementen 24 eingesetzt. Die einen Enden der Steckerelemente 24 der Messerleiste 23 ragen in den Aufnahmeschacht 22 hinein. Ferner ist das Gehäuse 16 auf der den Magnetventilen 12 gegenüberliegenden Seite von einem Deckel 25 abgeschlossen.

Die Anschlußpins 27 der Magnetventile 12 sind zum Beispiel durch Löten mit dem flexiblen Bereich 28 einer Leiterplatte 29 verbunden. Die Leiterplatte 29 besteht aus einer wärmeleitenden Platte 30 auf der eine (flexible) Leiterfolie 31 aufgebracht ist, die nicht dargestellte Leiterbahnen auf ihrer freien Oberfläche trägt. Diese Leiterplatten sind Bestandteile einer elektrischen Schaltung, von der hier nur einige diskrete Bauelemente 33 dargestellt sind. Diese diskreten Bauelemente 33 sind vorzugsweise als SMD-Bauelemente (surface-mounted-device) ausgebildet. Die elektronische Schaltung dient - auf ansich bekannte Weise - zur Ansteuerung der Magnetventile 12 (Verbraucher) des hydraulischen Brems-Blockierschutz-Systems.

Da die Leiterplatte 29 im Bereich der Anschlußpins 27 der Magnetventile 12 nur aus der Leiterfolie 31 besteht, können die Pins 27 in sehr einfacher Weise angebracht werden. Insbesondere können Toleranzunterschiede ausgeglichen werden, die bei einer Kontaktierung mit einer starren Leiterplatte entstehen können. Im Bereich der Platte 30 weist die Leiterplatte 29 Lötöffnungen 35 auf, durch die die anderen Enden der Steckerelemente 24 ragen. Ferner ist die Leiterfolie 31 auch auf der Innenseite des Deckels 25 aufgebracht. Hierzu ist zwischen der Platte 30 und dem Deckel 25 ein zweiter, flexibler schlaufenförmiger Bereich 36 an der Leiterplatte 29 ausgebildet, in dem sich die Leiterfolie 31 ohne Trägerplatte befindet. Die Länge dieses flexiblen Bereichs 36 ist dabei so abzustimmen, daß der Deckel 25 aufgeklappt werden kann. Dadurch ist es möglich, auch die Innenseite des Deckels 25 mit Leistungsbauelementen zu bestücken, wodurch die Bestückungsdichte der Leiterplatte 29 erhöht wird. Ferner kann durch eine geeignete Wahl des Werkstoffs für den Deckel auch die Wärme der Leistungsbauelemente in einfacher Weise ohne zusätzliche Kühlelemente abgeführt werden. Dies gilt auch für das Material der Platte 30.

Ist der Deckel 25 aufgeklappt, so sind alle Bereiche der Leiterplatte 29 von einer Seite her, d.h. senkrecht von oben her zugänglich und liegen ferner in einer Ebene, so daß alle Vorgänge in einem Arbeitsvorgang ausgeführt und vor allem in einem Vorgang, zum Beispiel dem bekannten Reflow-Löten, gelötet werden können. Selbstverständlich darf im schlaufenförmigen Bereich 26 die Leiterfolie 31 sich nicht berühren, um so einen elektrischen Kurzschluß zu vermeiden.

Durch die direkte Verbindung der Magnetventile 12 mit der Leiterfolie 31 im flexiblen Bereich 28 der Leiterplatte 29 entfallen zum Beispiel die Steckverbindungselemente und die Herstellung des Anbausteuergeräts wird einfach, da hier keine genauen Toleranzen einzuhalten sind. Gleichzeitig dient die Leiterfolie 31 auch als Anschluß für das nach außen führende Steckerelement 24. Mit Hilfe dieses Steckerelements 24 kann die elektronische Schaltung der Leiterplatte 29 mit Eingangssignalen von Sensoren (z.B. Drehzahlfühlern) versorgt werden. Zwischen der elektronischen Schaltung auf der Leiterplatte 29 und den Steckerelementen 24 sind keine separaten Verbindungsleitungen bzw. Anschlußleitungen nötig.

Meist werden das Anbausteuergerät 15 und der Verbraucher 10 an zwei verschiedenen Orten oder von zwei verschiedenen Produzenten hergestellt. Dadurch ist ein Transport eines der beiden Bauteile, zum Beispiel des Anbausteuergeräts 15 notwendig. Hierzu kann als Transportsicherung und als Staubabdichtung die untere Öffnung 13, d.h. die dem Motor zugewandte Öffnung 13 des Gehäuses 16, von einem zusätzlichen Deckel verschlossen werden.

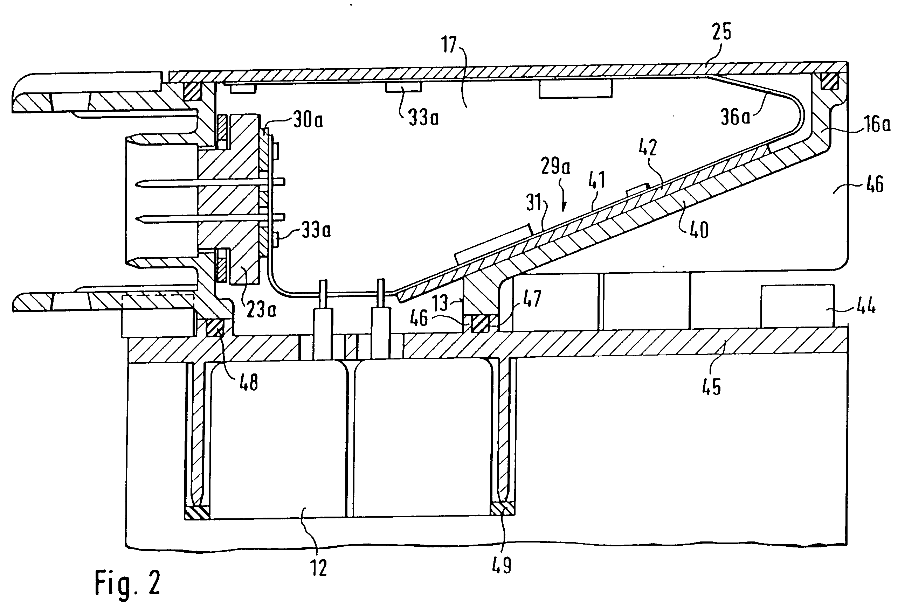

In der Abwandlung nach der Figur 2 hat das Gehäuse 16A an einer Stelle eine Wand mit einem schräg verlaufenden Abschnitt 40. Auf diesem Abschnitt 40 liegt ein starrer Bereich 41 der Leiterplatte 29A auf. Der Bereich 41 der Leiterplatte 29 besteht aus einem wärmeleitenden Träger 42, auf dem die Leiterfolie 31 aufgebracht ist, zum Beispiel aufgeklebt ist. Der schräg verlaufende Abschnitt 40 der Leiterplatte 29 sollte möglichst weit bis zur Öffnung und somit bis zum Deckel 25 führen, so daß der schlaufenartige Abschnitt 36A der Leiterplatte 29A so kurz wie möglich ausgebildet werden kann. Ferner sollte der schräge Abschnitt 40 auch möglichst weit bis zur anderen Öffnung 13 führen, durch die die Magnetventile 12 ins Innere 17 des Anbausteuergeräts 15 ragen. Dadurch wird der notwendige Auflagebereich des Anbausteuergeräts 15 auf den Motor 10 minimiert und die Verschraubungen der Anschlußplatte 45 des Motors 10 sind leicht zugänglich und sie können auch noch unter dem Gehäuse 16A des Anbausteuergeräts platzsparend angeordnet werden. Für eine leichte und sichere Wärmeabfuhr sind im Bereich des schrägen Abschnitts 40 am Gehäuse 16A des Anbausteuergeräts 15 Rippen 46 ausgebildet. Aufgrund der Schräge des Abschnitts 40 sind diese Rippen 46 noch ohne zusätzlichen Platzbedarf zwischen der Wand des Gehäuses 16A und der Platte 45 des Motors 10 auszubilden. Ferner ist im Unterschied zur Figur 1 die Platte 30A der Leiterplatte 29A direkt an der Messerleiste 23A befestigt. Dies ermöglicht eine kompakte Bauweise, da bereits an der Messerleiste 23A Leistungsbauelemente 33A anzuordnen sind.

Ferner ist es wichtig, daß zwischen dem Gehäuse 16A des Anbausteuergeräts 15 und dem Gehäuse des Motors 10A eine druckdichte Verbindung besteht. Hierzu weist die Druckplatte 45 eine umlaufende Krake 46 auf, in der eine Nut 47 für einen Dichtring 48 ausgebildet ist. Ferner weist die Druckplatte 45 eine in das Gehäuse des Motors 10A bzw. des Verbrauchers ragende Kante 48 auf, die ebenfalls mit Hilfe eines Dichtrings 49 abgedichtet ist. Dadurch wird sowohl zum Gehäuse 16A des Anbausteuergeräts 15 hin als auch zum Gehäuse des Motors 10A hin eine druckdichte Verbindung mit Hilfe der Druckplatte 45 hergestellt.

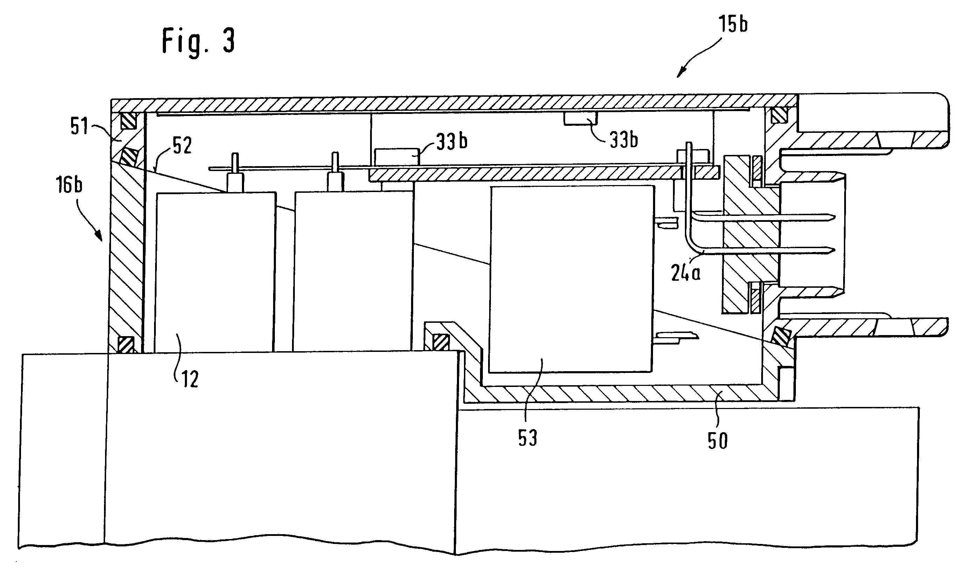

Die Ausbildung nach der Figur 3 dient dazu, um größere elektrische bzw. elektronische Bauteile, wie zum Beispiel ein Relais 53 im Gehäuse 16B des Anbausteuergeräts 15B mit unterzubringen, wobei das Gehäuse 16B aber weiterhin kompakt ausgebildet sein soll. Hierzu ist der Rahmen des Gehäuses 16B im Unterschied zu den Ausbildungen nach der Figur 1 und 2 mehrteilig ausgebildet und besteht aus einem wannenförmigen Bodenteil 50 und einem abgedichtet aufgesetzten Rahmenteil 51. Die Auflagefläche 52 des Rahmenteils 51 auf dem Bodenteil 50 ist schräg verlaufend, so daß das Rahmenteil 51 den gesamten Stecker und die Leiterplatte 29 aufnimmt. Die elektrischen Bauteile 33B und die Anschlüsse eines Relais 53 und die Anschlüsse der Magnetventile 12 sind somit weiterhin senkrecht zugänglich und montierbar. Dies ist möglich, da das Relais 53 mit den Steckerelementen 24A verbunden wird und anschließend das Bodenteil 50 im Sinne eines Deckels auf das Rahmenteil 51 aufgesetzt wird. Weiterhin kann bei der Montage und bei der Ausbildung wie bei dem oben beschriebenen Ausführungsbeispiel nach der Figur 1 bzw. nach der Figur 2 vorgegangen werden.

Der Einsatz des Anbausteuergeräts ist nicht auf die in den Ausführungsbeispielen beschriebenen Antiblockiersysteme (hydraulische Brems-Blockierschutz-Systeme) bzw. schlupfgeregelten hydraulischen Bremsanlagen beschränkt. Der Einsatz ist u.a. auch möglich bei Antriebsschlupfregelungssystemen, kombinierten Brems-Blockierschutz/Antriebsschlupfregelungs-Systemen oder bei Kraftstoffeinspritzsystemen und anderen Kombinationen von Elektronikeinheiten (Steuergerät und Verbrauchern).

## Patentansprüche

1. Anbausteuergerät (15) zur Ansteuerung von Verbrauchern (12), insbesondere den Magnetventilen eines Hydroaggregats einer schlupfgeregelten hydraulischen Bremsanlage, mit einem Gehäuse (16) zur Aufnahme einer Elektronikeinheit, insbesondere einer Leistungsendstufe, mit mindestens einer Leiterplatte (29), die eine elektronische Schaltung mit diskreten Bauelementen (33) trägt und mit den Anschlußelementen (27) der Verbraucher (12) verbunden ist, wobei die Anschlußelemente (27) der Verbraucher (12) in das Gehäuse (16) des Anbausteuergeräts (15) ragen und das Gehäuse (16) zu den Verbrauchern (12) hin offen ist und auf den Verbrauchern (12) aufliegt, und mit mindestens einem mit der Schaltung verbundenen Steckerelement (24), das von außen zugänglich ist, zum Anschließen von Sensoren oder dergleichen, wobei die Leiterplatte (29) eine Leiterfolie (31) aufweist, und die Verbraucheranschlüsse (27) und die Steckerelemente (24) direkt mit der Leiterfolie (31) verbunden sind, wobei das Gehäuse (16) aus mindestens zwei Gehäuseteilen (25, 16) besteht, und die Leiterplatte (29) aus mehreren starren (30, 25) und flexiblen (28, 36) Bereichen besteht, wobei mindestens zwei starre Bereiche (30, 25) durch einen flexiblen Folienbereich (36) verbunden sind, und ein starrer Bereich (25) der Leiterplatte (29) durch eine Gehäuseinnenseite eines Gehäuseteils (16, 25) gebildet ist, und die Leiterfolie (31) über die Leiterplatte (29) hinausragt und in diesem Bereich (28) unmittelbar mit den Anschlußelementen (27) der Verbraucher (12) verbunden ist.

2. Anbausteuergerät nach Anspruch 1, dadurch gekennzeichnet, daß das Gehäuse (16) aus einem wannenförmigen Gehäuseteil (16) und einem die Öffnung dieses Gehäuses abschließenden Deckel (25) besteht und daß ein Teil der Leiterplatte (29) an der Innenseite des Deckels (25) befestigt ist.

3. Anbausteuergerät nach Anpruch 2, dadurch gekennzeichnet, daß das wannenförmige Gehäuseteil aus einem Bodenteil (50) und einem kragenförmigen Teil (51) besteht, wobei die Schnittlinie (52) zwischen den beiden Gehäuseteilen (50, 51) schräg verläuft.

4. Anbausteuergerät nach einem der Ansprüche 1 bis 3, dadurch gekennzeichnet, daß die Leiterfolie (31) zumindest teilweise in den starren Bereichen auf einem wärmeleitenden Träger (30) angeordnet ist.

5. Anbausteuergerät nach einem der Ansprüche 1 bis 4, dadurch gekennzeichnet, daß das Steckerelement (24) an einer Stirnseite der Leiterfolie (31) angeordnet ist.

6. Anbausteuergerät nach einem der Ansprüche 1 bis 5, dadurch gekennzeichnet, daß die diskreten Bauelemente (33) der Schaltung als SMD-Bauelemente auf der Leiterfolie (31) angeordnet sind.

7. Anbausteuergerät nach einem der Ansprüche 1 bis 6, dadurch gekennzeichnet, daß die Leiterfolie (31) im Einbauzustand mindestens in zwei übereinanderliegenden Ebenen starre Abschnitte (25, 30) aufweist.

8. Anbausteuergerät nach einem der Ansprüche 1 bis 7, dadurch gekennzeichnet, daß die Leiterfolie (31) in Mehrlagentechnik ausgeführt ist.

9. Anbausteuergerät nach einem der Ansprüche 1 bis 8, dadurch gekennzeichnet, daß ein freier Abschnitt (36) der Leiterfolie (31) derart bemessen ist, daß ein Aufklappen des Deckels (25) in eine Ebene des anderen starren Bereichs (30) möglich ist.

## Claims

1. Built-on control device (15) for actuating loads (12), in particular the solenoid valves of a hydraulic unit of a traction controlled hydraulic brake system, having a housing (16) for receiving an electronic unit, in particular a power output stage, having at least one printed circuit board (29) which bears an electronic circuit having discrete components (33) and is connected to the connection elements (27) of the loads (12), the connection elements (27) of the loads (12) projecting into the housing (16) of the built-on control device (15) and the housing (16) being open towards the loads (12) and bearing on the loads (12), and having at least one plug element (24) which is connected to the circuit and is accessible from the outside, for connecting sensors or the like, the printed circuit board (29) having a conductor foil (31) and the load connections (27) and the plug elements (24) being directly connected to the conductor foil (31), characterized in that the housing (16) comprising at least two housing components (25, 16), and the printed circuit board (29) comprising a plurality of rigid (30, 25) and flexible (28, 36) regions, at least two rigid parts (30, 25) being connected by means of a flexible foil region (36), and a rigid region (25) of the printed circuit board (29) being formed by the inside of a housing component (16, 25), and the conductor foil (31) projecting beyond the printed circuit board (29) and being connected in this region (28) directly to the load connections (27) of the loads (12).

2. Built-on control device according to Claim 1, characterized in that the housing (16) comprises a trough-shaped housing component (16) and a lid (25) which seals off the opening of this housing, and in that part of the printed circuit board (29) is attached to the inside of the lid (25).

3. Built-on control device according to Claim 2, characterized in that the trough-shaped housing component comprises a base component (50) and a collar-shaped part (51), the intersection line (52) extending obliquely between the two housing components (50, 51).

4. Built-on control device according to one of Claims 1 to 3, characterized in that the conductor foil (31) is arranged at least partially in the rigid regions on a heat conducting carrier (30).

5. Built-on control device according to one of Claims 1 to 4, characterized in that the plug element (24) is arranged on one end side of the conductor foil (31).

6. Built-on control device according to one of Claims 1 to 5, characterized in that the discrete components (33) of the circuit are arranged as surface mounted devices on the conductor foil (31).

7. Built-on control device according to one of Claims 1 to 6, characterized in that the conductor foil (31) has, in the installation stage, rigid sections (25, 30) at least in two planes lying one on top of the other.

8. Built-on control device according to one of Claims 1 to 7, characterized in that the conductor foil (31) is realized using multilayer technology.

9. Built-on control device according to one of Claims 1 to 8, characterized in that a free section (36) of the conductor foil (31) is dimensioned such that it is possible to fold open the lid (25) into a plane of the other rigid region (30).

## Revendications

1. Appareil de commande auxiliaire (15) pour commander des utilisateurs (12), notamment des électrovannes, d'un groupe hydraulique d'une installation de freinage hydraulique antipatinage, comprenant un boîtier (16) logeant une unité électronique, notamment un étage de sortie de puissance, au moins une plaque de circuit imprimé (29) portant un circuit électronique avec des composants discrets (33) et des éléments de raccordement (27) des utilisateurs (12), les éléments de raccordement (27) des utilisateurs (12) arrivant dans le boîtier (16) de l'appareil de commande (15) et le boîtier (16) étant ouvert en direction des utilisateurs (12) et reposant sur les utilisateurs (12), ainsi qu'au moins un élément de connexion (24) relié au circuit et accessible de l'extérieur pour le branchement des capteurs ou autres, la plaque de circuit imprimé (29) ayant une feuille conductrice (31) et les branchements d'utilisateur (27) ainsi que les éléments de connexion (24) étant reliés directement à la feuille conductrice (31),
le boîtier (16) se composant d'au moins deux parties (25, 16) et la plaque de circuit imprimé (29) se composant de plusieurs zones rigides (30, 25) et flexibles (28, 36), au moins deux zones rigides (30, 25) étant reliées par une zone de feuille flexible (36), une zone rigide (25) de la plaque de circuit imprimé (29) étant formée par un côté intérieur d'une partie de boîtier (16, 25), et la feuille conductrice (31) dépassant de la plaque de circuit imprimé (29) en étant reliée directement, dans cette zone (28), aux éléments de branchement (27) des utilisateurs (12).

2. Appareil de commande selon la revendication 1,
caractérisé en ce que
le boîtier (16) se compose d'une partie en forme de cuvette (16) et d'un couvercle (25) fermant l'ouverture de l'autre partie, et la partie de plaque de circuit imprimé (29) est fixée sur le côté intérieur du couvercle (25).

3. Appareil selon la revendication 2,
caractérisé en ce que
la partie de boîtier en forme de cuvette se compose d'un fond (50) et d'une pièce en forme de collerette (51), la ligne de coupe (52) entre les deux parties (50, 51) étant dirigée en biais.

4. Appareil de commande selon l'une des revendications 1 à 3,
caractérisé en ce que
la feuille conductrice (31) arrive au moins partiellement dans les zones rigides, sur un support (30) conducteur de la chaleur.

5. Appareil de commande selon l'une des revendications 1 à 4,
caractérisé en ce que
l'élément de connexion (24) est prévu sur une face frontale de la feuille conductrice (31).

6. Appareil de commande selon l'une des revendications 1 à 5,
caractérisé en ce que
les composants discrets (33) du circuit sont des composants en technique SMD montés sur la feuille conductrice (31).

7. Appareil de commande selon l'une des revendications 1 à 6,
caractérisé en ce que
la feuille conductrice (31) comporte, à l'état monté, au moins deux segments rigides (25, 30) situés dans des plans superposés.

8. Appareil de commande selon l'une des revendications 1 à 7,
caractérisé en ce que
la feuille conductrice (31) est réalisée en technique multicouche.

9. Appareil de commande selon l'une des revendications 1 à 8,
caractérisé en ce qu'
un segment libre (36) de la feuille conductrice (31) est dimensionné pour permettre l'ouverture par rabattement du couvercle (25) dans un plan de l'autre zone rigide (30).
